# EUROPÄISCHE PATENTSCHRIFT

(11) **EP 2 016 449 B1**
(45) Veröffentlichungstag und Bekanntmachung des Hinweises auf die Patenterteilung: **30.06.2021**
(21) Anmeldenummer: 07718430.7
(22) Anmeldetag: 08.05.2007
(51) Int. Cl.: H05K 1/02, G02B 6/42, G02B 6/138

(54) **VERFAHREN ZUR HERSTELLUNG EINES OPTOELEKTRONISCHEN BAUELEMENTS**
METHOD OF MANUFACTURING AN OPTOELECTRONIC COMPONENT
UN PROCÉDÉ DE FABRICATION UN COMPOSANT OPTOÉLECTRONIQUE

(30) Priorität: 08.05.2006 AT 7922006
(43) Veröffentlichungstag der Anmeldung: 21.01.2009
(73) Patentinhaber: AT & S Austria Technologie & Systemtechnik Aktiengesellschaft, 8700 Leoben-Hinterberg (AT)
(72) Erfinder: RIESTER, Markus, A-8054 Seiersberg (AT); LANGER, Gregor, 9061 Wölfnitz (AT); STUCK, Alexander, CH-5430 Wettingen (CH)
(74) Vertreter: Sonn & Partner Patentanwälte
(86) Internationale Anmeldenummer: PCT/AT2007/000216
(87) Internationale Veröffentlichungsnummer: WO 2007/128021

(56) Entgegenhaltungen:
- EP-A- 1 004 907
- EP-A- 1 109 041
- JP-A- 2005 338 696
- US-A1- 2003 152 113
- US-A1- 2004 005 119
- US-B1- 6 690 845

## Beschreibung

Die Erfindung betrifft ein Verfahren zur Herstellung eines optoelektronischen Bauelements, wie z.B. VCSEL-Bauelement oder Photodiode, mit einer Licht-Durchtrittsfläche, gemäß dem Oberbegriff von Anspruch 1.

Ein derartiges optoelektronisches Bauelement ist aus JP 2005-338 696 A bekannt.

Optoelektronische (Halbleiter-)Bauelemente, wie z.B. VCSEL-Bauelemente (VCSEL-Vertical Cavity Surface Emitting Laser), geben ihre Licht- bzw. Laserstrahlung vielfach vertikal zum Substrat, d.h. im rechten Winkel zu ihrer gewünschten oder normalen Einbaurichtung, ab. In dieser Abstrahlrichtung ist die Bauhöhe der optoelektronischen Bauelemente am geringsten, wogegen die Abmessungen senkrecht zur Abstrahlrichtung größer sind, insbesondere ein Mehrfaches der Dickenabmessung der Bauelemente betragen. Dies schafft Probleme bei der Integration eines derartigen Bauelements in einem Leiterplattenelement mit Licht-Wellenleiter, da die Bestückung des Substrats hochkant erfolgen muss, wenn die Abstrahlung des Lichts parallel zur Hauptebene des Leiterplattenelements gewünscht ist. Diese Hochkant-Bestückung ist jedoch problematisch, da sie nicht im Zuge einer automatischen Standard-Bestückung erfolgen kann. Weiters ist die Kontaktierung der Bauelemente schwierig, wobei insbesondere aufwändige, teure Bonddraht-Verbindungen erforderlich sind. Überdies führt die Hochkant-Bestückung zu relativ großen Abmessungen der Leiterplattenelemente in Dickenrichtung, wobei aber in der Regel in dieser Dickenrichtung geringe Abmessungen angestrebt werden.

Aus der US 2003/0156327 A ist ein flaches, plattenförmiges Licht-Umlenkelement bekannt, das eine gekrümmte Spiegelfläche senkrecht zur Haupt-Plattenebene hat, um Licht, das von einem gesondertem Bauelement, z.B. einem Glasfaserkabel, an einer Eintrittsfläche zugeführt wird, in der Ebene des plattenförmigen Licht-Umlenkelements um ca. 90° zu einer Austrittsfläche umzulenken, wo ein weiteres gesondertes Bauelement das Licht empfängt. Auch dieses Licht-Umlenkelement wäre für einen Einbau in einem Leiterplattenelement, um Licht von einem vertikal zum Substrat abstrahlenden optoelektronischen Bauelement in die Ebene des Leiterplattenelements umzulenken, hochkant anzuordnen. Darüberhinaus wäre der Einbau dieses gesonderten Umlenkelements auch hinsichtlich der Platzierung mit der erforderlichen Genauigkeit aufwendig. In entsprechender Weise gilt dieser Nachteil auch für die gesonderten Spiegelelemente bei den Anordnungen gemäß der JP 61 - 133 911 A, bei der ein vorgefertigter Spiegel auf einem LED - oder Photodetektor - Bauelement angebracht wird, und gemäß der DE 37 06 255 A, bei der ein lichtzündbarer Thyristor ein Lichtsignal über einen vom Thyristor gesonderten, starren Lichtumlenker, z.B. ein Prisma oder einen an einen flexiblen Lichtleiter anschließenden Glaskrümmer, zugeführt erhält.

Aus der WO 01/16630 A1 ist ein Multilayer-Leiterplattenelement bekannt, bei dem optoelektronische Bauelemente, insbesondere VCSEL-Bauelemente, in Verbindung mit einem Licht-Wellenleiter vorgesehen sind. Ein Ausweg für einen flachen Einbau der VCSEL-Bauelemente in der Leiterplatte wurde dabei so gesehen, dass das jeweilige VCSEL-Bauelement in einer Pufferschicht benachbart einer optischen Wellenleiter-Schicht eingebaut wird, und dass ein planer, schräg gestellter Umlenkspiegel in der Wellenleiter-Schicht vorgesehen wird, um den emittierten Laserstrahl um 90° in die Wellenleiter-Schicht umzulenken. Bei dieser Bauweise ist aber die Ausrichtung des VCSEL-Bauelements und des zugehörigen Umlenkspiegels kritisch. Weiters ist hier eine flächige optische Wellenleiter-Schicht zwischen Pufferschichten vorgesehen, innerhalb von der der Laserstrahl mit Hilfe des Umlenkspiegels ausgerichtet werden muss. Notwendig ist hierfür daher auch, dass ein enger, gebündelter Laserstrahl vom VCSEL-Bauelement erzeugt und vom Umlenkspiegel weitergeleitet wird.

Es ist andererseits bereits bekannt, in einem organischen oder anorganischen optischen, photopolymerisierbaren Material eine optische Wellenleiterstruktur mit Hilfe von Photonen-Absorptionsprozessen zu erzeugen, wobei das optische Material lokal beim Bestrahlen mit Photonen derart umgewandelt wird, dass es einen größeren Brechungsindex aufweist, verglichen mit dem nicht strukturierten ursprünglichen optischen Material. Dies ist im Zusammenhang mit Optokoppler-Bauelementen beispielsweise aus WO 01/96915 A2, WO 01/96917 A2 und US 4 666 236 A bekannt. Eine vergleichbare Wellenleiter-Strukturierung in einer optischen, photopolymerisierbaren Schicht ist im Zusammenhang mit einem Leiterplattenelement weiters bereits aus WO 2005/064381 A1 bekannt, wobei die darin beschriebene Technik den Ausgangspunkt für die vorliegende Erfindung darstellt. Insbesondere ist im Zusammenhang mit Fig. 15 dieser WO 2005/064381 A1 ein Leiterplattenelement mit einem VCSEL-Bauelement geoffenbart, wobei dieses VCSEL-Bauelement ebenfalls flach im Leiterplattenelement integriert ist und so in Querrichtung des Leiterplattenelements vertikal nach oben abstrahlt. Um den Laserstrahl dann in einem horizontalen Licht-Wellenleiter in der Ebene des Leiterplattenelements propagieren zu lassen, ist gemäß dieser bekannten Technik ein an das VCSEL-Bauelement anschließender vertikaler Abschnitt und ein daran anschließender, in den horizontalen Wellenleiter übergehender bogenförmiger Knieabschnitt des Licht-Wellenleiters notwendig, was jedoch zwangsläufig wiederum zu einer relativ großen Dicke des Leiterplattenelements führt. Diese Ausbildung ist vor allem bei der beschriebenen Wellenleiter-Strukturierung mit einem Mehrphotonen-Absorptionsprozess problematisch, da mit dieser Technik der Photonenbestrahlung in der Regel nur geringe Brechungsindex-Unterschiede bewirkt werden. Daher haben auf diese Weise strukturierte Licht-Wellenleiter, die an sich wegen ihrer Lichtbündelungswirkung ähnlich Glasfasern bevorzugt werden, den Nachteil, dass sie Licht nur über Kurven mit relativ großen Radien leiten können. Eine Umlenkung des Lichts um 90° bedingt daher einen Radius (und somit auch eine Schichtdicke des optischen Materials) von mehreren mm bis cm und führt somit zu großen Dicken der Leiterplattenelemente.

Es ist weiters beispielsweise aus der EP 1 512 993 A1 und aus der EP 1 460 738 A2 bekannt, bei optoelektronischen Bauelementen optische Linsen, etwa zur Einstellung des Divergenzwinkels eines VCSEL-Bauelements mittels diffraktiver Optik, in einem Replikationsverfahren zu erzeugen. Dabei wird ein Abformprozess zum Formen einer Mehrzahl von Linsen auf einem VCSEL-Wafer mit Hilfe einer entsprechenden Form sowie mit einer Aushärtung durch UV-Strahlung, des Linsenmaterials nach dem Abformen verwendet. Andererseits wurde in der JP 02 - 234 476 A bereits ein LED-Halbleiterbauelement mit integriertem Umlenkspiegel vorgeschlagen, der aus dem Halbleitermaterial des Bauelements gebildet ist und Licht zu einer Glasfaser umlenkt. Die Herstellung dieses Umlenkspiegels erfolgt offensichtlich durch eine in der Halbleitertechnologie übliche Photo-Ätz-Technik.

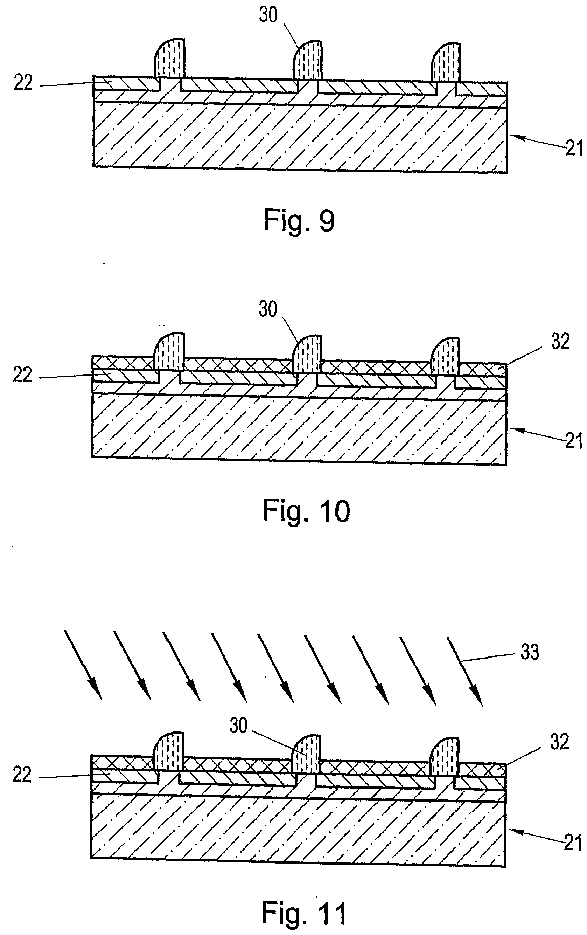

Die US 6,690,845 B1 beschreibt dreidimensionale optoelektronische Module, insbesondere Multichipmodule, wobei in einer Ausführungsform (Fig. 9 und 10) eines solchen Multichipmoduls u.a. ein VCSEL-Element als optoelektronisches Bauelement enthalten ist, oberhalb von dem in einem Abstand ein Umlenkspiegel angeordnet ist. Der Spiegel ist dabei über einen Lichtwellenleiter mit dem VCSEL gekoppelt.

In der EP 1 109 041 A1 ist ein optisches Modul mit einem optischen Sender oder Empfänger geoffenbart, der auf einem Leiterplattenelement montiert ist; auf diesem Leiterplattenelement ist überdies ein gesonderter gehäuseartiger transparenter Körper angebracht, der außen an einem Vorsprung mit einem Umlenkspiegel ausgebildet ist, um Licht in einem Glasfaser-Lichtleiter zu lenken oder aus diesem zugeführt zu erhalten und zum Empfänger umzulenken.

Aus der US 2003/0152113 A1 ist weiters eine optoelektronische Baueinheit bekannt, bei der über einem Array-Chip und einem gesonderten Zwischenteil ein gesonderter optischer Block angeordnet ist, in dem an den Grenzflächen eine Mehrfach-Totalreflexion von Licht erfolgt, das über eine Linse und einen an einem anderen Zwischenteil vorgesehenen Spiegel in den optischen Block eingekoppelt wird. Eine ähnliche Anordnung in Form eines Demultiplexers ist in der EP 1 004 907 A2 beschrieben; im Einzelnen ist hier ein Spiegel in einem optischen Hauptblock an einen Vorsprung geformt, und zwar oberhalb eines davon getrennten Linsenblocks, unterhalb von dem ein Detektor-Array angeordnet ist. Aus der US 2004/0005119 A1 ist weiters eine optoelektonische Baueinheit bekannt, bei der über dem optoelektonischen Chip ein Lichtwellenleiter angeordnet ist, bei dem eine gebogene reflektierende Oberfläche am Eingangsbereich anwesend ist.

Die WO 2006/012819 A1 offenbart ein Halbleiterbauelement, das ähnlich den zuletzt angeführten Baueinheiten einen Chip-Träger aufweist, auf dem ein Halbleiterlaserchip - als das eigentliche optoelektronische Bauelement - angebracht ist. Über gesonderte Distanzelemente ist ein eigener Träger für einen Umlenkspiegel mit dem Chip-Träger verbunden, so dass der Umlenkspiegel in Abstand vom eigentlichen optoelektronischen Bauelement, dem Halbleiterlaserchip, vorliegt.

Aus der JP 2005-338 696 ist ein optoelektronisches Bauelement bekannt, bei dem ein Umlenkspiegel vorgesehen ist, der nach Formung seines transparenten Harzteiles in einer Harzform mit einem Wafer bzw. Halbleitersubstrat, das das Bauelement enthält, unter Erhitzen und Pressen verbunden wird. Dabei wird auf einen genauen Ausrichtvorgang der beiden Komponenten hingewiesen.

Es ist nun Aufgabe der Erfindung, ein Verfahren zur Herstellung eines optoelektronischen Bauelements wie eingangs angegeben vorzusehen, wobei es in einer herstellungsmäßig einfachen und kostengünstigen Weise ermöglicht wird, Licht in einer planaren Anordnung von Bauelementen und optischen Wellenleitern parallel zur Oberfläche abzustrahlen oder zu empfangen, auf der das jeweilige Bauelement flach aufgesetzt wird, so dass eine einfache Standardbestückung und -kontaktierung sowie auch eine außerordentlich geringe Gesamt-Bauhöhe der Leiterplattenelemente erzielt werden können. Weiters wird bei der Erfindung auch angestrebt, Licht bei einer Umlenkung im Bereich des optoelektronischen Bauelements gleichzeitig zu fokussieren.

Zur Lösung der gestellten Aufgabe sieht die Erfindung ein Verfahren wie in Anspruch 1 angegeben vor. Vorteilhafte Ausführungsformen und Weiterbildungen sind in den abhängigen Ansprüchen definiert.

Mit der erfindungsgemäßen Technik wird die Herstellung eines optoelektronischen Bauelements ermöglicht bei dem eine Einkopplung des Lichts in den Licht-Wellenleiter (oder aber vom Licht-Wellenleiter in das Bauelement) auf eine solche Weise ermöglicht wird, dass eine Bestückung der Leiterplattenelemente mit den optoelektronischen Bauelementen in einem automatischen Vorgang, eine einfache Kontaktierung (z.B. eine Kontaktierung der Unterseite mittels leitfähigem Kleber bei der Bestückung, und/oder eine nachträgliche Kontaktierung der Oberseite mittels µ-Vias) möglich ist; überdies wird eine außerordentlich flache Bauweise, somit eine außerordentlich geringe Dicke des Leiterplattenelements insgesamt, in dem ein solches Bauelement mit integriertem Umlenkspiegel eingebettet ist, ermöglicht, wobei andererseits die Herstellung kostengünstig ist. Mit Vorteil wird durch den Umlenkspiegel auch gleichzeitig mit der Umlenkung des Lichts eine Fokussierung des Strahls, insbesondere in den Wellenleiter hinein, ermöglicht, was bei der an sich zu bevorzugenden Technik der Strukturierung von Licht-Wellenleitern mit Hilfe des beschriebenen Photonenprozesses von besonderem Vorteil ist. Beim vorliegenden Verfahren wird das optoelektronische Bauelement mit seinem optischen Aufbau, nämlich dem Umlenkspiegel, in einem optischen Material eingebettet, anders als bei den VCSEL-Bauelementen gemäß Stand der Technik mit Linsen, wo ein Einsatz an Luft vorgesehen ist, wobei dann mit diffraktiver Optik gearbeitet wird. Das üblicherweise verwendete optische Replikationsmaterial für den optischen Aufbau (Linsen gemäß Stand der Technik, Umlenkspiegel gemäß der vorliegenden Erfindung), z.B. ein Sol-Gel-Material, hat einen Brechungsindex von ca. n = 1,5. Dieser Brechungsindex von ca. 1,5 reicht aus, um in Luft (mit einem Brechungsindex n = 1) eine ausreichende Linsenwirkung zu erzielen. Wenn jedoch - wie bei der vorliegenden Technik - das System in ein optisches Material eingebettet wird, welches ebenfalls einen Brechungsindex bei ca. 1,5 besitzt, kann nicht mit einer diffraktiven Optik gearbeitet werden, sondern es wird eine refraktive Optik vorgesehen. Insbesondere wird der Umlenkspiegel, beispielsweise durch Aufbringen einer dünnen Metallschicht, an seiner Außenseite verspiegelt. Mit Vorteil wird die Fokussierung des Lichtstrahls durch einen asphärischen Spiegel bewerkstelligt.

Durch den genannten Umlenkspiegel mit einer Umlenkung des Strahls um beispielsweise 90° sowie mit einer Fokussierung wird die Erzeugung von integrierten optischen Verbindungen in Leiterplattenelementen wie im Detail in der vorstehend genannten WO 2005/064381 A1 beschrieben ermöglicht. Zur weiteren Erläuterung von derartigen Systemen wird auf dieses WO-Dokument verwiesen, dessen Offenbarung, insbesondere auch hinsichtlich des bekannten TPA-Prozesses (TPA - Two-Photon-Absorption - Zweiphotonenabsorption) für die Wellenleiter-Strukturierung, durch Bezugnahme hier mit eingeschlossen sein soll.

Das optisch transparente Material des Umlenkspiegels ist insbesondere ein UV-aushärtendes Material, um die Herstellung am Bauelemente-Halbleiter-Wafer mit einem Replikationsverfahren, wie an sich bekannt, und durch eine anschließende UV-Aushärtung nach der Formgebung zu ermöglichen. Das Material kann beispielsweise ein Silikonmaterial oder ein anorganisch-organisches Hybridpolymer, wie unter der Bezeichnung Ormocer® bekannt, nämlich ein organisch modifiziertes Keramikmetall, insbesondere ein Hybridpolymer auf Basis von Silikon, von einem organischen Polymer und von Glas oder Keramik, sein. Andererseits kann das transparente Material des Umlenkspiegels auch ein einfaches thermoplastisches oder aber duroplastisches Material sein, wie z.B. Polycarbonat, Polymethylmethacrylat oder Polystyrol bzw. ausgehärtete Epoxyd- oder Polyesterharze. Die Brennweite des Umlenkspiegels kann beispielsweise höchstens 5000µm, beispielsweise zwischen 50pm und 5000pm, betragen. Als Metall für die Verspiegelung des Umlenkspiegels an seiner Rückseite kann insbesondere Gold oder Silber verwendet werden, wobei die Schichtdicke dieser Metallschicht beispielsweise ca. 100nm bis zu einigen µm betragen kann.

Insbesondere dann, wenn der Umlenkspiegel auch eine Bündelung bzw. Fokussierung des (Laser-)Strahls bewirkt, ist es auch mit Vorteil möglich, dass der strukturierte Licht-Wellenleiter in einem Abstand vor dem Umlenkspiegel endet. Dies ist bei der Herstellung des Licht-Wellenleiters durch die Photonenbestrahlung (Zwei- bzw. Mehrphotonenabsorption) von Vorteil, da mit der Photonenbestrahlung gegebenenfalls auch knapp vor Erreichen des Umlenkspiegels bzw. des Bauelements gestoppt werden kann, um so jegliches Risiko für das Bauelement zu vermeiden.

Bei der Strukturierung der Licht-Wellenleiter innerhalb der optischen Schicht kann mit Vorteil derart vorgegangen werden (vgl. WO 2005/064381 A1), dass das bereits in der optischen Schicht eingebettete optoelektronische Bauelement mit Hilfe einer Kamera oder dgl. optischen Beobachtungseinheit anvisiert und hinsichtlich seiner Position erfasst wird; über diese Beobachtungseinheit wird sodann eine Bestrahlungseinheit mit einem Linsensystem angesteuert, um so einerseits den Fokusbereich des abgegebenen Photonenstrahls, insbesondere Laserstrahls, in der Ebene des Leiterplattenelements, d.h. in der x/y-Ebene, zu bewegen und andererseits auch in der Tiefe innerhalb der optischen Schicht, also in der z-Richtung, einzustellen. Somit kann, mit dem jeweiligen optoelektronischen Bauelement als Bezugselement, der Licht-Wellenleiter innerhalb der optischen Schicht in der gewünschten Weise strukturiert werden, etwa als einfache geradlinige Licht-Wellenleiter-Verbindung oder aber als Wellenleiterstruktur mit Verzweigungen, mit Krümmungen oder dgl. Strukturen, insbesondere auch als dreidimensionale Struktur. Die Querschnitts-Abmessungen des so strukturierten Licht-Wellenleiters können beispielsweise in der Größenordnung von einigen Mikrometern liegen, wobei der Querschnitt eines solchen strukturierten Licht-Wellenleiters beispielsweise kreisförmig, aber auch elliptisch oder rechteckig sein kann; die genaue Form kann durch den Photonenstrahl und dessen Fokus-Steuerung bestimmt werden.

Bevorzugt wird zur Wellenleiter-Strukturierung der bereits erwähnte, an sich bekannte Photonen-Prozess angewandt, bei dem eine chemische Reaktion (z.B. Polymerisation) durch gleichzeitige Absorption von zwei (oder mehr) Photonen aktiviert wird. Von Vorteil ist dabei, dass durch die Transparenz des optischen Materials für die Anregungswellenlänge alle Punkte im Volumen erreicht und somit problemlos dreidimensionale Strukturen in das Volumen eingeschrieben werden können, wobei weiters sehr kleine Fokusbereiche und somit sehr kleine Strukturdimensionen erzielt werden können. Überdies ist der Mehrphotonen-Prozess ein einfacher Einschritt-Strukturierungsprozess.

Mit den vorliegenden Leiterplattenelementen werden Multimode- oder Singlemode-Wellenleiter-Datenübertragungen mit außerordentlich hohen Datentransferraten bei einer gleichzeitig großen Designfreiheit ermöglicht. Derartige Leiterplattenelemente können in Form von optoelektrischen Backplanes oder Flex-Leiterplatten, insbesondere für Mobiltelefone, Handhelds und dergleichen elektronische Rechner- und Kommunikationseinheiten, verwendet wer-den. Hierbei kann eine besonders vorteilhafte Nutzung der speziellen Eigenschaften von VCSEL-Bauelementen für die Einkopplung von Laserlicht in eingebettete Wellenleiter erfolgen, wobei von besonderer Bedeutung die geringe Wärmetönung durch die geringe Leistungsaufnahme, eine optimale Abstrahlcharakteristik und ein geringer Preis sind.

Die Erfindung wird nachfolgend anhand von besonders bevorzugten Ausführungsbeispielen, auf die sie jedoch nicht beschränkt sein soll, und unter Bezugnahme auf die Zeichnung noch weiter erläutert. In der Zeichnung zeigen im Einzelnen:
Fig. 1A und 1B als Beispiel für ein optoelektronisches Bauelement ein herkömmliches VCSEL-Bauelement in Aufsicht bzw. Ansicht;
Fig. 2A und 2B in vergleichbaren Darstellungen, in Aufsicht bzw. Ansicht, ein VCSEL-Bauelement mit integriertem Umlenkspiegel;
Fig. 3 einen schematischen Querschnitt durch einen Teil eines Leiterplattenelements mit einem optoelektronischen Bauelement, insbesondere VCSEL-Bauelement, und einem damit optisch gekoppelten Licht-Wellenleiter;
die Fig. 4 bis 13 verschiedene Stufen bei der Herstellung von integrierten Umlenkspiegeln an, an einem Halbleiter-Wafer vorgesehenen VCSEL-Bauelementen gemäß einem an sich bekannten Replikationsverfahren, wobei aber überdies auch, anders als bei dem an sich bekannten Verfahren, eine Verspiegelung der Umlenkspiegel vorgesehen ist;
Fig. 14 in einer schematischen Schnittdarstellung ähnlich Fig. 3 eine modifizierte Ausführungsform eines Leiterplattenelements mit einem optoelektronischen Bauelement; und
Fig. 15 eine Draufsicht ähnlich jener gemäß Fig. 2A auf ein modifiziertes optoelektronisches Bauelement, nämlich VCSEL-Bauelement, mit zwei Kontaktflächen an seiner Oberseite.

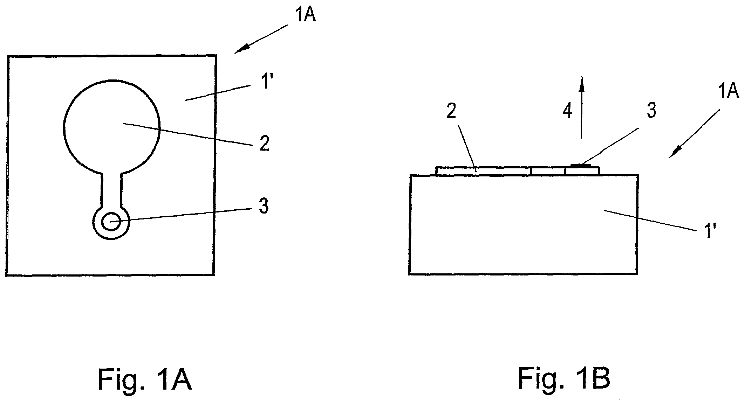

In den Fig. 1A und 1B ist ganz schematisch ein VCSEL-Laserbauelement 1A gemäß Stand der Technik gezeigt, wobei auf den hier nicht näher zu beschreibenden Halbleiterkörper 1' des VCSEL-Bauelements 1A eine Kontaktfläche 2, beispielsweise aus Gold, in Verbindung mit einer Laserlicht-Emissionsfläche 3 vorgesehen ist. Die Abstrahlrichtung des vom gezeigten VCSEL-Bauelement 1 emittierten Laserstrahls ist in Fig. 1B mit einem Pfeil 4 angedeutet.

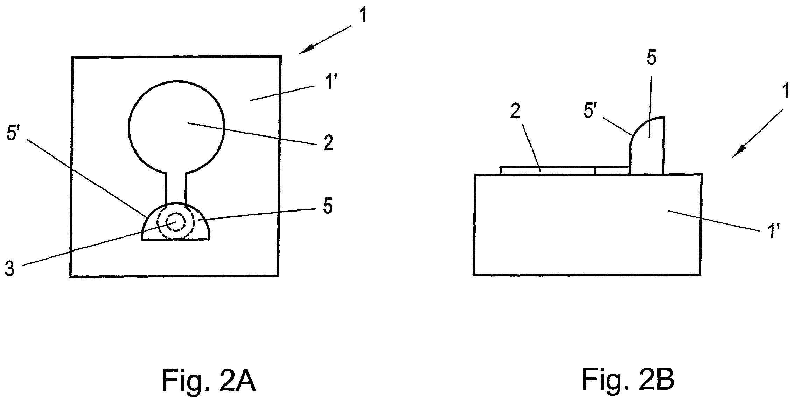

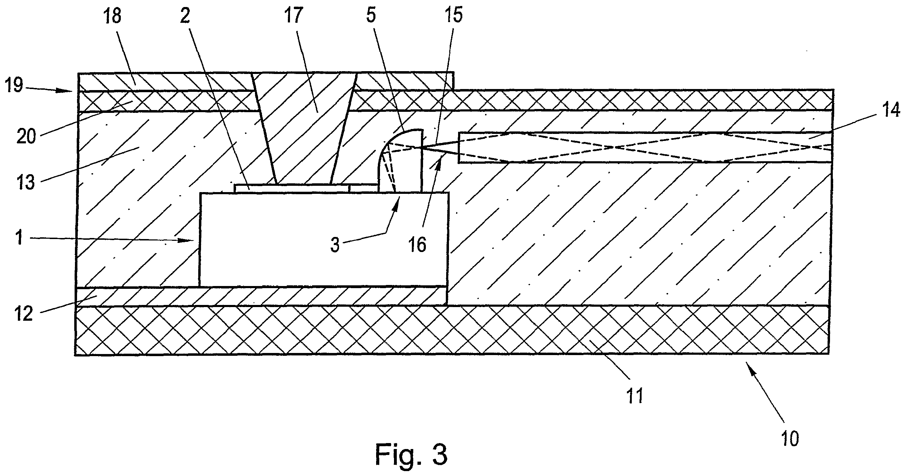

In den Fig. 2A (Aufsicht) und 2B (Seitenansicht) ist in einer vergleichbaren, ebenfalls ganz schematischen Darstellung ein VCSEL-Bauelement 1 - als Beispiel für ein optoelektronisches Bauelement, insbesondere ein Licht emittierendes optoelektronisches Bauelement - mit einem Halbleiterkörper 1' und mit einer Kontaktfläche 2, z.B. aus Gold, gezeigt, wobei weiters über der ähnlich wie in Fig. 1 vorgesehenen fensterförmigen Laserlicht-Emissions- bzw. Durchtrittsfläche 3 in Fig. 2 unmittelbar auf dem VCSEL-Bauelement 1 bzw. dessen Halbleiterkörper 1' ein Umlenkspiegel 5 aufgebaut ist. Mit anderen Worten, der Umlenkspiegel 5 befindet sich direkt über der Licht-Durchtrittsfläche 3, nachstehend kurz Emissionsfenster 3 genannt, so dass das vom VCSEL-Bauelement 1 erzeugte Laserlicht direkt in diesen Umlenkspiegel 5 gelangt und von diesem umgelenkt sowie gebündelt wird, wie nachstehend noch näher anhand von Fig. 3 erläutert werden wird.

Der Umlenkspiegel 5 besteht aus einem transparenten Material, das abgeformt werden kann, wie z.B. aus einem anorganischorganischen Hybridpolymer, das im Handel unter der Bezeichnung Ormocer® bekannt ist. Ein anderes Material, das hierfür verwendet werden kann, ist Silikon. Der Umlenkspiegel 5 hat eine Form ungefähr gemäß der Hälfte einer Halbkugel, wie sich aus der Zusammenschau der Figuren 2A und 2B ergibt, und er ist an seiner Außenseite oder Rückenfläche verspiegelt. Diese Verspiegelung wird mit Hilfe einer dünnen Metallschicht 5', etwa aus Gold oder Silber, insbesondere mit einer Schichtdicke von 100nm bis zu einigen µm, realisiert.

Die gezeigte Spiegelfläche des Umlenkspiegels 5 kann außer als die Form eines Ausschnitts einer Kugelfläche auch eine andere gekrümmte Form haben, und insbesondere ist ein asphärischer Spiegel mit sich von Punkt zu Punkt änderndem Radius für die vorliegenden Zwecke der optimalen Einkopplung von Laserlicht in einen Licht-Wellenleiter innerhalb eines Leiterplattenelements von besonderem Vorteil.

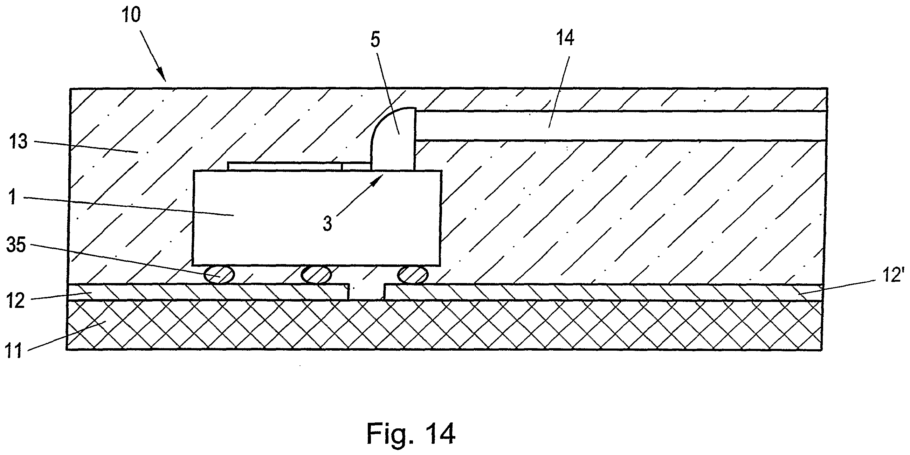

Ein solches Leiterplattenelement 10 ist schematisch und ausschnittsweise in Fig. 3 gezeigt. Das gezeigte Leiterplattenelement 10 hat ein Leiterplattensubstrat 11, z.B. ein herkömmliches FR4-Substrat oder aber ein Substrat in Form einer Polyimidfolie, wenn flexible Leiterplattenelemente gewünscht sind. Auf diesem Substrat 11 befindet sich eine Kontaktfläche 12, insbesondere in Form einer Kupferlage, wobei in der Darstellung von Fig. 3 die Kontaktfläche bereits nach der Strukturierung (durch ein übliches Photo-Ätz-Verfahren) gezeigt ist. Auf dem Substrat 11 bzw. über der Kontaktfläche 12 ist eine Schicht aus einem optischen, photopolymerisierbaren Material 13 vorhanden, wobei in dieser optischen Schicht 13 das optoelektronische Bauelement (VCSEL-Bauelement) 1 eingebettet ist. Diese Einbettung kann beispielsweise auf die in der WO 2005/064381 A1 beschriebene Weise erhalten werden, indem das Bauelement 1 auf dem Substrat 11 bzw. auf der Kontaktfläche 12 angebracht, z.B. angeklebt wird, wonach das optische Material der Schicht 13 durch ein herkömmliches Verfahren, z.B. Rakel-Verfahren, aufgebracht wird. Im Anschluss daran wird auf die ebenfalls in der WO 2005/064381 beschriebene Art und Weise, mit Hilfe eines Zwei-Photonen-Prozesses, durch gezielte und gesteuerte Bestrahlung des optischen Materials der Schicht 13 im gewünschten Bereich, ein strukturierter, Lichtfaser-artiger Licht-Wellenleiter 14 erzeugt, in den das vom Bauelement 1 abgegebene und mit Hilfe des Umlenkspiegels 5 umgelenkte und überdies gebündelte Laserlicht 15 eingekoppelt wird. Dabei spielt es keine Rolle, wenn sich der Licht-Wellenleiter 14 wie in Fig. 3 dargestellt nicht bis direkt zur Vorderseite des transparenten Teils des Umlenkspiegels 5 erstreckt, sondern ein geringer Abstand 16 vorhanden ist, um so bei der Strukturierung des Licht-Wellenleiters 14 im optischen Material der Schicht 13 kein Risiko hinsichtlich einer Beeinträchtigung des Bauelements 1 einzugehen, da durch die gezeigte Umlenkung und Bündelung des Laserlichts 15 nichtsdestoweniger eine optimale Einkopplung in den Licht-Wellenleiter 14 erzielt wird. Selbstverständlich ist es aber auch möglich und vielfach vorgesehen, dass der Licht-Wellenleiter 14 direkt an das Bauelement 1 herangeführt ist, d.h. kein Abstand 16 vorhanden ist, wie dies auch bei der nachstehend noch näher zu erläuternden Ausführungsform nach Fig. 14 vorgesehen ist, vgl. hierzu im Übrigen auch die WO 2005/064381 A1.

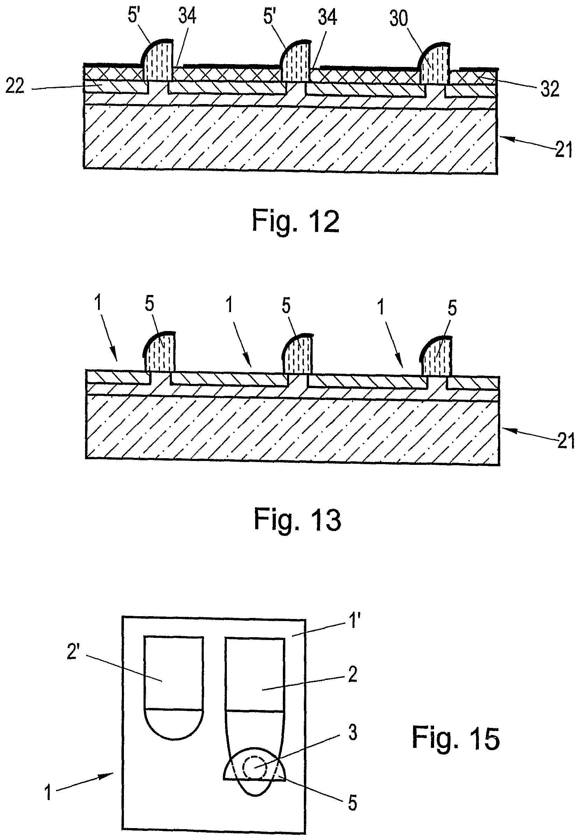

In Fig. 3 ist weiters noch schematisch der Bereich des Laser-Emissionsfensters 3 angedeutet, und weiters ist die obere Kontaktfläche 2 des VCSEL-Bauelements 1 gezeigt, die beispielsweise über eine Mikro-Via-Laserbohrung (µ-Via-Laserbohrung) 17 mit einer Kontaktfläche 18 einer oberen Leiterplattenlage 19 in elektrischer Verbindung steht, welche aus dieser - in Fig. 3 bereits strukturiert gezeigten - Kontaktfläche 18 (z.B. wiederum aus Kupfer) sowie einem beispielsweise vergleichsweise dünnen Substrat bzw. einer Isolier- und Klebeschicht 20, z.B. einer Epoxydharzschicht, besteht. Das gezeigte Leiterplattenelement 10 hat somit eine Multilayer-Struktur, wobei zwei mit leitenden Flächen versehene Isolierlagen vorgesehen sind, und wobei die Leiterlagen zur Erzielung der Kontaktflächen und Leiterbahnen 12, 18 auf bekannte Weise lithographisch strukturiert wurden. Bei der in Fig. 3 gezeigten Ausbildung hat das VCSEL-Bauelement 1 eine untere Kontaktfläche, die mit der Kontaktfläche 12 elektrisch verbunden ist, sowie die obere Kontaktfläche 2, die über die µ-Via-Laserbohrung 17 mit der oberen Kontaktfläche 18 verbunden ist. Anstatt dessen ist es aber selbstverständlich weiters auch möglich, dass das VCSEL-Bauelement 1 beide Kontaktflächen an einer seiner Oberflächen besitzt und somit z.B. von oben über zwei µ-Via-Laserbohrungen vergleichbar der µ-Via-Laserbohrung 17 in Fig. 3 mit gesonderten Leiterbahnen bzw. Kontaktflächen an der Oberseite des Leiterplattenelements 10 kontaktiert wird, vgl. auch Fig. 15. In diesem Fall kann das VCSEL-Bauelement 1 auch auf einer Wärmeableitschicht, beispielsweise aus Kupfer, auf dem Substrat 11 angebracht sein, wie dies in der WO 2005/064381 A erläutert ist. Andererseits kann das Bauelement 1 auch beide Kontakte auf der Unterseite (Flip-Chip-Technologie) besitzen und so mittels Lötbällen auf das Substrat 11 kontaktiert werden. Das Bauelement 1 wird auf diese Weise bereits bei der Bestückung vollständig kontaktiert, und es werden keine µ-Vias benötigt, vgl. Fig. 14.

Überdies ist es auch denkbar, dass im Fall der Ausbildung gemäß Fig. 3 die obere Kontaktfläche oder Leiterlage 18 mit einem an sich bekannten Additionsverfahren direkt auf die Schicht 13 aus dem optischen, photopolymerisierbaren Material aufgebracht wird, so dass die Isolier- und Klebeschicht 20 nicht benötigt wird und insbesondere auch das obere Einzel-Leiterplattenelement 19 sich erübrigen kann.

Von besonderer Bedeutung ist, dass bei der vorliegenden Anordnung das optoelektronische Bauelement, also insbesondere das VCSEL- oder Photodioden-Bauelement, 1 einen integrierten Umlenkspiegel 5 aufweist, der den Laserstrahl 15 nicht nur um 90° umlenkt, wie aus Fig. 3 ersichtlich ist, sondern auch den Laserstrahl 15 bündelt, d.h. eine Linsenwirkung aufweist, um so die Einkopplung des Laserlichts in den Licht-Wellenleiter 14 zu optimieren.

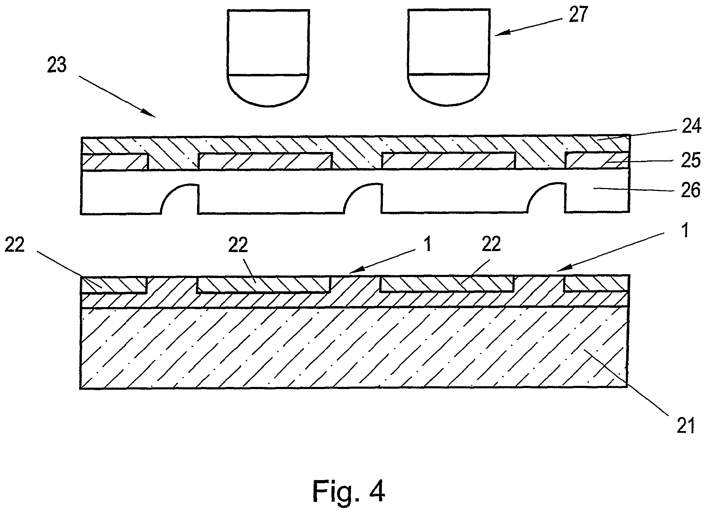

Um an einem derartigen Bauelement 1 einen integrierten Umlenkspiegel 5 herzustellen, wird eine Technik wie in den Fig. 4 bis 13 gezeigt angewandt, wobei ähnlich dem an sich bekannten Replikationsverfahren zur Herstellung von Mikrolinsen auf VCSELs, vgl. beispielsweise EP 1 512 993 A1 und EP 1 460 738 A2, vorgegangen wird. Ergänzend wird jedoch bei der vorliegenden Technik noch eine Verspiegelung der optischen Strukturen oder Aufbauten (nämlich des Umlenkspiegels) durch einen Beschichtungsprozess, z.B. durch Bedampfen, vorgesehen, wie dies nachfolgend anhand der Fig. 11 und 12 erläutert werden wird.

Im Einzelnen ist aus Fig. 4 ein Wafer 21 ersichtlich, auf dem sich bereits vorgefertigte optoelektronische Bauelemente 1, nämlich insbesondere VCSEL-Bauelemente 1, befinden, zwischen denen Kontaktregionen 22 zur Separation der Bauelemente 1 vorgesehen sind. Oberhalb hiervon ist in Fig. 4 in Abstand vom Wafer 21 ein Maskensubstrat 23 gezeigt, welches im Einzelnen ein UVtransparentes Substrat 24, eine darin angebrachte UVundurchlässige Struktur 25 sowie eine UV-transparente Form 26 aufweist. Wieder oberhalb von dieser Maske 23 ist schematisch ein Mikroskop 27 veranschaulicht, welches dazu verwendet wird, um eine Vorjustierung der Maske 23 relativ zum Wafer 21 vorzunehmen.

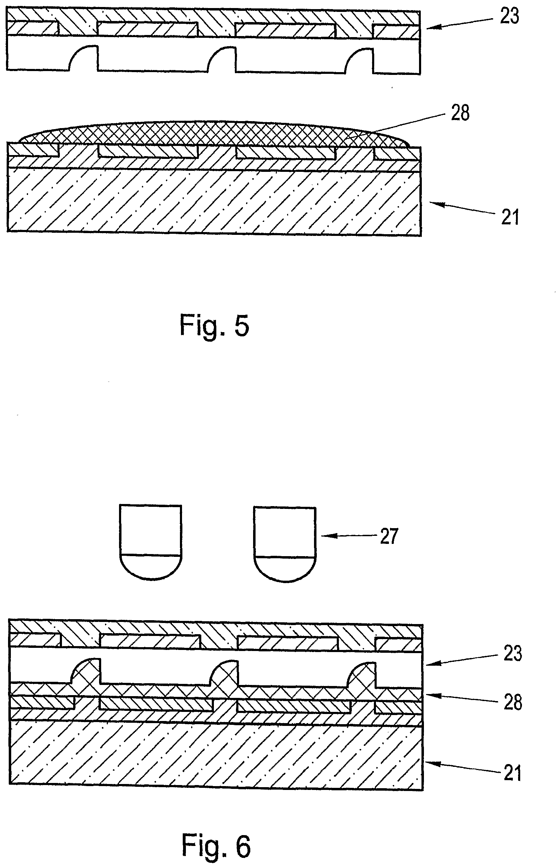

In Fig. 5 ist sodann in schematischer Zuordnung zum Wafer 21 mit darüber vorgesehener Maske 23 ein optisches Replikationsmaterial 28 gezeigt, wobei es sich hier bevorzugt um eine Dispension eines Sol-Gel-Materials, wie an sich bekannt, handelt.

In Fig. 6 ist der Aufbau aus Wafer 21, optischem Replikationsmaterial 28 und Maske 23 mit Mikroskop 27 gezeigt, wobei nunmehr eine genaue Ausrichtung von Maske 23 und Wafer 21 relativ zueinander mit Hilfe des Mikroskops 27 durchgeführt wird.

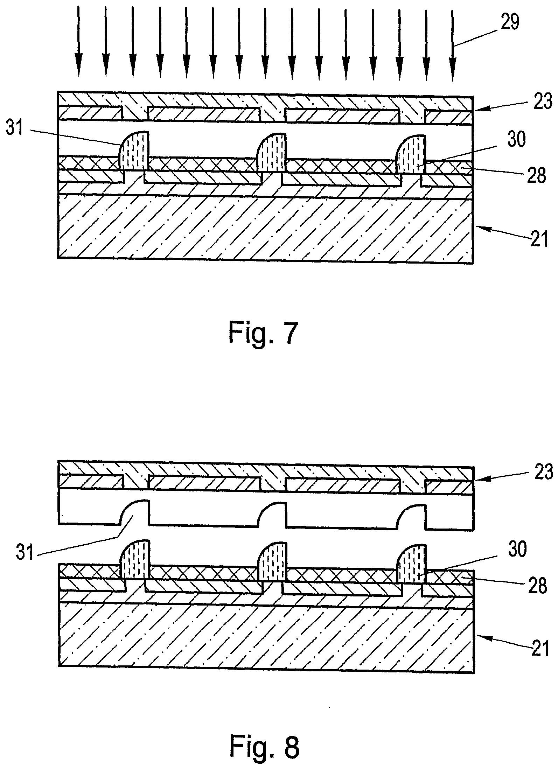

Im Anschluss daran erfolgt gemäß Fig. 7 eine Belichtung des Sol-Gel-Materials, also der optischen Replikationsschicht 28, wobei UV-Licht 29 durch die Maske 23 hindurch gerichtet wird, und wobei belichtete Bereiche 30 gezeigt sind, die die gewünschten Umlenkspiegel 5 (siehe Fig. 2 und 3) bilden werden. Durch die Belichtung mit UV-Licht 29, gemäß den Pfeilen in Fig. 7, wird das optische Replikationsmaterial 28 an den belichteten Bereichen 30 ausgehärtet.

Danach kann eine Entformung durch Abheben der Maske 23 vom Wafer 21 erfolgen, und die durch Belichten und Aushärten abgeformten Bereiche 30 werden ebenso wie die Form 31 danach in an sich herkömmlicher Weise gereinigt, vgl. Fig. 8.

Im Anschluss daran erfolgt gemäß Fig. 9 eine Strukturierung in einem Photo-Ätz-Prozess, wobei Fig. 9 die Struktur nach dem Entwickeln (Ätzen, Waschen) des nicht belichteten optischen Replikationsmaterials 28 zeigt.

In Fig. 10 ist eine durch Photolitographie aufgebrachte Photoresiststruktur 32 auf dem Wafer 21 gezeigt, die zur Maskierung der metallischen Kontaktregionen 22 bei einem nachfolgenden Beschichtungsvorgang dient.

Im Einzelnen werden dabei die zuvor belichteten und UV-gehärteten Bereiche 30 des Replikationsmaterials beschichtet, und zwar beispielsweise, wie in Fig. 11 schematisch gezeigt ist, durch Bedampfen der gekrümmten Außenseite oder Rückenfläche der Bereiche 30 mit Metall (Gold oder Silber), wobei die Bedampfungsrichtung schräg ist, wie durch die Pfeile 33 in Fig. 11 veranschaulicht ist. Auf diese Weise wird die mit der Verspiegelung bzw. Metallschicht 5' versehene Struktur gemäß Fig. 12 erhalten, wobei auch ersichtlich ist, dass durch die Schattenwirkung der transparenten Bereiche 30 Teile 34 der Photoresiststruktur 32 nicht bedampft wurden.

In Fig. 13 ist schließlich die nach Entfernen der Photoresiststruktur 32 erhaltene endgültige Konfiguration des Wafers 21 mit den (VCSEL-)Bauelementen 1 samt Umlenkspiegeln 5 gezeigt. Aus diesem Wafer 21 werden schließlich die einzelnen Bauelemente 1 in an sich herkömmlicher Weise durch Schneiden erhalten, wobei ein derartiges (VCSEL-)Bauelement 1 in den Fig. 2 und 3 dargestellt ist.

Als Material für den Umlenkspiegel 5 kann auch ein transparentes thermoplastisches oder duroplastisches Material verwendet werden, wie etwa Polycarbonat, Polymethylmethacrylat oder Polystyrol bzw. ausgehärtete Epoxyd- oder Polyesterharze. Bei Verwendung eines derartigen Materials kann sich bei der Herstellung der Umlenkspiegel über den optoelektronischen Bauelementen auf dem Wafer 21 die Bestrahlung mit UV-Licht 29, gemäß Fig. 7, erübrigen.

In Fig. 14 ist ein Leiterplattenelement 10 in einer Schnittdarstellung ähnlich wie in Fig. 3 gezeigt, wobei im Unterschied zu Fig. 3 ein optoelektronisches Bauelement 1, insbesondere VCSEL-Bauelement 1, mit zwei nicht näher ersichtlichen Kontaktflächen an seiner dem Substrat 11 zugewandten Unterseite versehen ist. Über diese Kontaktflächen wird mit Hilfe von Lötkugeln 35 der elektrische Kontakt zu Kontaktflächen, insbesondere Kupferflächen, 12 bzw. 12' auf dem Substrat 11 hergestellt. An seiner Oberseite ist das Bauelement 1 frei von Kontaktflächen, und in Entsprechung zur Ausbildung gemäß Fig. 3 ist an dieser Oberseite des Bauelements 1 wiederum ein Umlenkspiegel 5 oberhalb der Licht-Durchtrittsfläche 3 vorgesehen. Dieser Umlenkspiegel 5 kann wiederum ähnlich wie vorstehend anhand der Fig. 4 bis 13 erläutert hergestellt sein, er kann aber auch wie erwähnt aus einem thermohärtenden Material, also einem Thermoplast oder aber einem Duroplast, mit entsprechender Transparenz, geformt werden.

In Fig. 14 ist weiters wiederum die optische Schicht 13 mit dem darin mit Hilfe eines TPA-Prozesses strukturierten Wellenleiter 14 gezeigt, wobei sich nunmehr der Wellenleiter 14 beispielhaft bis direkt an die Stirnseite des Umlenkspiegels 5 heran erstreckt, d.h. der in Fig. 3 gezeigte Abstand 16 ist in der Ausführungsform gemäß Fig. 14 entfallen.

In Fig. 15 ist schließlich ein VCSEL-Bauelement 1 in einer schematischen Draufsicht ähnlich jener gemäß Fig. 2A gezeigt, wobei ersichtlich ist, dass sich zwei Kontaktflächen 2, 2' an der ersichtlichen Oberseite des Bauelements 1, auf dessen Halbleiterkörper 1', befinden, nämlich eine Anode 2 und eine Katode 2'. Weiters ist aus dieser Draufsicht gemäß Fig. 15 wiederum das beispielsweise kreisförmige Emissionsfenster 3, allgemein die Licht-Durchtrittsfläche 3, ersichtlich, wobei wiederum darüber der in Draufsicht ersichtliche Umlenkspiegel 5 vorgesehen ist.

Wenn vorstehend insbesondere auf VCSEL-Bauelemente als bevorzugte optoelektronische Bauelemente 1 Bezug genommen wurde, so sind doch selbstverständlich auch andere optoelektronische Bauelemente (Licht-Sender ebenso wie Licht-Empfänger) denkbar, wie insbesondere auch Photodioden.

## Patentansprüche

1. Verfahren zur Herstellung eines optoelektronischen Bauelements (1), welches Bauelement (1) eine Licht-Durchtrittsfläche (3) und einen Umlenkspiegel (5) aus einem optisch transparenten Material mit verspiegelter Rückenfläche aufweist, wobei der Umlenkspiegel (5) die passierende Licht-Strahlung (15) um einen vorgegebenen Winkel umlenkt, wobei sich das optoelektronische Bauelement (1) auf einem Wafer (21) befindet und der Umlenkspiegel (5) aus einem zum Abformen und Aushärten geeigneten Material hergestellt wird, wobei, das zum Abformen und Aushärten geeignete Material (28) direkt auf einer Licht-Durchtrittsfläche (3) des optoelektronischen Bauelements (1) aufgebracht und auf dieser in einem Bereich (30) entsprechend dem gewünschten Umlenkspiegel geformt wird, wonach das geformte Material (28) im Bereich (30) des Umlenkspiegels ausgehärtet wird, **dadurch gekennzeichnet, dass** das geformte Material im Bereich des Umlenkspiegels durch Bedampfen aus einer schräg auf dessen geformte Rückenfläche gerichteten Bedampfungsrichtung mit einer Metallschicht (5') verspiegelt wird.

2. Verfahren nach Anspruch 1, **dadurch gekennzeichnet, dass** die Aushärtung des geformten Materials (28) durch UV-Bestrahlung (29) unter Verwendung einer Maske (23) durchgeführt wird.

3. Verfahren nach Anspruch 1, **dadurch gekennzeichnet, dass** als zum Abformen und Aushärten geeignetes Material ein transparentes Thermoplast oder Duroplast, wie z.B. Polycarbonat, Polymethylmethacrylat oder Polystyrol, bzw. ein ausgehärtetes Epoxyd- oder Polyesterharz verwendet wird.

4. Verfahren nach Anspruch 1, **dadurch gekennzeichnet, dass** als transparentes Material ein Silikon oder ein anorganisch-organisches Hybridpolymer, beispielsweise ein organisch modifiziertes Keramikmaterial, insbesondere ein Hybridpolymer auf Basis von Silikon, von einem organischen Polymer und von Glas oder Keramik, verwendet wird.

5. Verfahren nach Anspruch 1, **dadurch gekennzeichnet, dass** der Umlenkspiegel (5) als ein die Licht-Strahlung (15) fokussierender refraktiver Spiegel oder Hohlspiegel ausgebildet wird.

6. Verfahren nach einem der Ansprüche 1 bis 5, **dadurch gekennzeichnet, dass** das Verspiegeln durch schräges Aufdampfen von Gold oder Silber durchgeführt wird.

7. Verfahren nach einem der Ansprüche 1 bis 6, **dadurch gekennzeichnet, dass** der Umlenkspiegel (5) als asphärischer Spiegel ausgebildet wird.

8. Verfahren nach einem der Ansprüche 1 bis 7, **dadurch gekennzeichnet, dass** der Umlenkspiegel (5) mit einer Fokuslänge von höchstens 5000µm ausgebildet wird.

9. Verfahren nach einem der Ansprüche 1 bis 8, **dadurch gekennzeichnet, dass** das optoelektronische Bauelement (1) ein VCSEL-Bauelement ist.

10. Verfahren nach einem der Ansprüche 1 bis 8, **dadurch gekennzeichnet, dass** das optoelektronische Bauelement (1) eine Photodiode ist.

## Claims

1. Method for producing an optoelectronic component (1), which component (1) has a light passage surface (3) and a deflecting mirror (5) that is made of an optically transparent material and has a mirrored rear surface, the deflecting mirror (5) deflecting the passing light radiation (15) by a predetermined angle, the optoelectronic component (1) being located on a wafer (21), and the deflecting mirror (5) being made of a material suitable for moulding and curing, the material (28) suitable for moulding and curing being applied directly to a light passage surface (3) of the optoelectronic component (1) and being shaped thereon in a region (30) corresponding to the desired deflecting mirror, after which the shaped material (28) is cured in the region (30) of the deflecting mirror, **characterised in that** the shaped material in the region of the deflecting mirror is mirrored with a metal coating (5') by means of vapour deposition from a vapour deposition direction that is oriented obliquely with respect to the shaped rear surface of said deflecting mirror.

2. Method according to claim 1, **characterised in that** the shaped material (28) is cured by UV irradiation (29) using a mask (23).

3. Method according to claim 1, **characterised in that** a transparent thermoplastic or thermoset, such as polycarbonate, polymethyl methacrylate or polystyrene, or a cured epoxy resin or polyester resin, is used as the material suitable for moulding and curing.

4. Method according to claim 1, **characterised in that** a silicone or an inorganic-organic hybrid polymer, for example an organically modified ceramic material, in particular a hybrid polymer based on silicone, on an organic polymer and on glass or ceramic, is used as the transparent material.

5. Method according to claim 1, **characterised in that** the deflecting mirror (5) is designed as a refractive mirror or concave mirror which focuses the light radiation (15).

6. Method according to any of claims 1 to 5, **characterised in that** the mirroring is carried out by oblique vapour deposition of gold or silver.

7. Method according to any of claims 1 to 6, **characterised in that** the deflecting mirror (5) is designed as an aspherical mirror.

8. Method according to any of claims 1 to 7, **characterised in that** the deflecting mirror (5) is designed with a focal length of at most 5000 µm.

9. Method according to any of claims 1 to 8, **characterised in that** the optoelectronic component (1) is a VCSEL component.

10. Method according to any of claims 1 to 8, **characterised in that** the optoelectronic component (1) is a photodiode.

## Revendications

1. Procédé pour fabriquer un composant optoélectronique (1), lequel composant (1) présente une surface de passage de la lumière (3) et un miroir de déviation (5) en un matériau optiquement transparent avec une surface dorsale revêtue d'une couche réfléchissante, où le miroir de déviation (5) dévie le rayonnement lumineux passant (15) d'un angle prédéterminé, où le composant optoélectronique (1) se trouve sur une galette (21) et le miroir de déviation (5) est fabriqué en un matériau approprié pour le moulage et le durcissement, où le matériau (28) approprié pour le moulage et le durcissement est appliqué directement sur une surface de passage de la lumière (3) du composant optoélectronique (1) et est façonné sur celle-ci dans un domaine (30) correspondant au miroir de déviation souhaité, après quoi le matériau façonné (28) est durci dans le domaine (30) du miroir de déviation, **caractérisé en ce que** le matériau façonné est revêtu d'une couche réfléchissante avec une couche métallique (5') dans le domaine du miroir de déviation par évaporation sous vide depuis une direction d'évaporation sous vide dirigée obliquement sur sa surface dorsale façonnée.

2. Procédé selon la revendication 1, **caractérisé en ce que** le durcissement du matériau façonné (28) est réalisé par irradiation UV (29) à l'aide d'un masque (23).

3. Procédé selon la revendication 1, **caractérisé en ce qu'**une matière thermoplastique ou thermodurcissable transparente, comme par exemple le polycarbonate, le poly(méthacrylate de méthyle) ou le polystyrène, ou une résine époxy ou polyester durcie est utilisée comme matériau approprié pour le moulage et le durcissement.

4. Procédé selon la revendication 1, **caractérisé en ce qu'**un silicone ou un polymère hybride inorganique-organique, par exemple un matériau céramique modifié de manière organique, en particulier un polymère hybride à base de silicone, d'un polymère organique et de verre ou de céramique, est utilisé comme matériau transparent.

5. Procédé selon la revendication 1, **caractérisé en ce que** le miroir de déviation (5) est réalisé sous la forme d'un miroir réfringent ou miroir concave focalisant le rayonnement lumineux (15).

6. Procédé selon l'une des revendications 1 à 5, **caractérisé en ce que** le revêtement avec une couche réfléchissante est réalisé par évaporation sous vide oblique d'or ou d'argent.

7. Procédé selon l'une des revendications 1 à 6, **caractérisé en ce que** le miroir de déviation (5) est réalisé sous la forme d'un miroir asphérique.

8. Procédé selon l'une des revendications 1 à 7, **caractérisé en ce que** le miroir de déviation (5) est réalisé avec une longueur focale d'au plus 5000 µm.

9. Procédé selon l'une des revendications 1 à 8, **caractérisé en ce que** le composant optoélectronique (1) est un composant VCSEL.

10. Procédé selon l'une des revendications 1 à 8, **caractérisé en ce que** le composant optoélectronique (1) est une photodiode.
